# EUROPEAN PATENT SPECIFICATION

(11) **EP 4 080 231 B1**
(45) Date of publication and mention of the grant of the patent: **14.02.2024**
(21) Application number: 22165149.0
(22) Date of filing: 29.03.2022
(51) Int. Cl.: G01R 31/66, G01R 31/67, G01R 31/00

(54) **METHOD FOR DETERMINING A CONNECTION STATUS BETWEEN AN ANTENNA AMPLIFIER AND AN ANTENNA STRUCTURE, A DIAGNOSTIC MODULE AND AN ANTENNA AMPLIFIER**
VERFAHREN ZUM BESTIMMEN EINES VERBINDUNGSZUSTANDS ZWISCHEN EINEM ANTENNENVERSTÄRKER UND EINER ANTENNENSTRUKTUR, DIAGNOSEMODUL UND ANTENNENVERSTÄRKER
PROCÉDÉ PERMETTANT DE DÉTERMINER UN ÉTAT DE CONNEXION ENTRE UN AMPLIFICATEUR D'ANTENNE ET UNE STRUCTURE D'ANTENNE, MODULE DE DIAGNOSTIC ET AMPLIFICATEUR D'ANTENNE

(30) Priority: 22.04.2021 DE 102021110345
(43) Date of publication of application: 26.10.2022
(73) Proprietor: Hirschmann Car Communication GmbH, 72654 Neckartenzlingen (DE)
(72) Inventor: SCHAICH, Peter, 72654 Neckartenzlingen (DE); LAEMMLE, Olaf, 72654 Neckartenzlingen (DE)
(74) Representative: Patentanwaltskanzlei WILHELM & BECK

(56) References cited:
- DE-A1- 19 820 207
- JP-A- 2010 232 927
- KR-A- 20110 052 236
- US-A- 5 293 173
- US-A1- 2006 055 395

## Description

The present invention relates to a method for determining a connection status between an antenna amplifier and an antenna structure. The present invention further relates to a diagnostic module for carrying out the method, and an antenna amplifier.

When using window heaters in vehicles in combination as heating systems and as antenna structures, it is necessary to be able to determine whether an antenna amplifier is connected to the antenna structure. For this purpose, diagnostic measurements of voltages or currents at connections between the antenna amplifier and the antenna structure are known from the prior art. However, for unambiguous interpretation of the voltage or current values measured in this way, information is required with respect to a connecting point at which the antenna amplifier is connected to the antenna structure.

US 2006/055395 A1 discloses diagnostic procedure relating to the connection of an antenna. T

US 5 293 173 A describes a signal separating device for separating a radio signal from the heating element of an electrically heated motor vehicle window to enable such heating element to be used as a radio antenna.

The object of the present invention is to provide an improved method for determining a connection status between an antenna amplifier and an antenna structure, a diagnostic module for carrying out the method, and an antenna amplifier comprising a diagnostic module.

The object of the present invention is achieved via the method, via the diagnostic module, and via the antenna amplifier according to the independent patent claims. Advantageous embodiments are the subject matter of the subordinate claims. According to one aspect of the present invention, a method is provided for determining a connection status between an antenna amplifier and an antenna structure, wherein the antenna structure is configured as a window antenna for a vehicle and comprises at least one heating wire of a window heater for a vehicle, and wherein the method comprises:
Applying a first diagnostic voltage to a connecting link between the antenna amplifier and the antenna structure, and reading out a first voltage value at a measurement point of the connecting link, wherein the first voltage value is determined as a difference in potential between a potential at the measurement point of the connecting link and a ground potential;
Comparing the first voltage value with the first diagnostic voltage;
Applying a second diagnostic voltage, which is different from the first diagnostic voltage, to the connecting link, and reading out a second voltage value at the measurement point of the connecting link, wherein the second voltage value is determined as a difference in potential between a potential at the measurement point of the connecting link and the ground potential;
Comparing the second voltage value with the second diagnostic voltage; and
Determining a faulty connection between the antenna amplifier and the antenna structure if the first voltage value corresponds to the first diagnostic voltage and the second voltage value corresponds to the second diagnostic voltage.

It is hereby possible to achieve the technical advantage of being able to provide an improved method for determining a connection status between an antenna amplifier and an antenna structure, wherein the antenna structure is configured as a window antenna for a vehicle and comprises at least one heating wire of a window heater for a vehicle.

Through the use of two different diagnostic voltages and the comparison of the recorded voltage values with the respective diagnostic voltages, the connection status between the antenna amplifier and the antenna structure may be determined without having to know whether the window heater of the antenna structure is switched on or off. Through the use of the different diagnostic voltages, it is possible to avoid the case in which, by chance, a diagnostic voltage applied to the connecting link for determining the connection status corresponds to a potential of a switching element of the window heater. In such a case, in which the applied diagnostic voltage corresponds to the potential of the switching element, it would not be possible to distinguish whether a faulty connection exists between the antenna amplifier and the antenna structure, or whether a fault-free connection exists between the antenna amplifier and the antenna structure, but the switching element of the window heater is switched to the closed state, and thus the potential of the switching element corresponds to the applied diagnostic voltage. In both cases, a correspondingly measured voltage value would correspond to the respectively applied diagnostic voltage.

By using two different diagnostic voltages, the faulty connection between the antenna amplifier and the antenna structure may be clearly determined if the measured voltage values respectively correspond to the two different diagnostic voltages. In addition, by means of the method according to the present invention, it is possible to determine a connection status without knowledge of a connecting point at which the antenna amplifier is connected to the antenna structure via the connecting link. The method according to the present invention is thus applicable to any antenna structures having different connecting points at which corresponding antenna amplifiers can be connected.

A connection status is indicated here by means of a fault-free connection between the antenna amplifier and the antenna structure, or by means of a faulty connection between the antenna amplifier and the antenna structure.

According to one embodiment, the method further comprises:
Determining a fault-free connection between the antenna amplifier and the antenna structure if the first voltage value differs from the first diagnostic voltage and/or the second voltage value differs from the second diagnostic voltage.

It is hereby possible to achieve the technical advantage of providing a clear method for determining a connection status between an antenna amplifier and an antenna structure. If, based on the measurements described above, at least one of the first or second voltage values differs from the respective first or second diagnostic voltage, a fault-free connection between the antenna amplifier and the antenna structure may be determined. By using two different diagnostic voltages again in each case, the fault-free connection may be achieved without knowledge of a switching state of a switching element of the window heater and without knowledge of a connecting point of the antenna amplifier at the antenna structure.

According to one embodiment, a faulty connection is indicated if the antenna amplifier is not connected to the antenna structure via a connecting element.

It is hereby possible to achieve the technical advantage that, by means of the detection of the faulty connection, it is possible to detect that the antenna amplifier is not connected to the antenna structure via a corresponding connecting element. The detection of a faulty connection is thus not limited to damage to the connecting link, but also enables the detection of a faulty connection of the antenna amplifier.

According to one embodiment, the first diagnostic voltage and the second diagnostic voltage are applied to the connecting link via a diagnostic resistor.

It is hereby possible to achieve the technical advantage of enabling a precise determination of the first and second voltage values, or the first and second diagnostic voltages, in that voltages dropping across the diagnostic resistor may be tapped. A precise and simple measurement of the voltage values is hereby made possible.

According to one embodiment, the first diagnostic voltage and/or the second diagnostic voltage and/or the first voltage value and/or the second voltage value are DC voltages.

It is hereby possible to achieve the technical advantage of enabling a simple and precise measurement method for determining the matches between the diagnostic voltages and the read-out voltage values.

According to one embodiment, the method is carried out cyclically during an operation of the antenna amplifier and the antenna structure.

It is hereby possible to achieve the technical advantage of being able to determine a connection status of the antenna amplifier with the antenna structure at any time during the operation. A change in the connection status may thus be determined at any time.

According to one embodiment, the method is carried out during a switch-on operation of the antenna amplifier and/or the antenna structure.

It is hereby possible to achieve the technical advantage of being able to provide a connection status in a switch-on operation of the antenna amplifier or antenna structure.

According to one embodiment, the antenna structure and the window heater may be integrated into a rear window or a front window or a side window of a vehicle.

It is hereby possible to achieve the technical advantage of being able to provide a method for determining a connection status for antenna structures which may be integrated together with a window heater in rear windows, front windows or side windows of a vehicle.

According to a second aspect of the present invention, a diagnostic module is provided for determining a connection status between an antenna amplifier and an antenna structure, wherein the diagnostic module is connectable to the antenna amplifier and the antenna structure, wherein the diagnostic module comprises a generation unit for generating diagnostic voltages, and a readout unit for reading out voltage values and comparing the voltage values with the diagnostic voltages, and wherein the diagnostic module is configured to carry out the method according to the present invention for determining a connection status between an antenna amplifier and an antenna structure according to one of the preceding embodiments.

It is hereby possible to achieve the technical advantage of being able to provide an improved diagnostic module for determining a connection status between an antenna amplifier and a separation structure, said module being configured to carry out the method according to the present invention having the aforementioned technical advantages.

According to one embodiment, the generation unit comprises a microcontroller, wherein the microcontroller comprises a digital-to-analogue converter and/or a pulse width modulation output, and wherein the microcontroller is arranged to generate the first diagnostic voltages and the second diagnostic voltages.

It is hereby possible to achieve the technical advantage of enabling a precise and reliable provision of the first and second diagnostic voltages.

According to one embodiment, the readout unit comprises an analogue-to-digital converter and/or a comparator, wherein the readout unit is configured to compare the first voltage value with the first diagnostic voltage, and the second voltage value with the second diagnostic voltage.

It is hereby possible to achieve the technical advantage of enabling a precise and reliable readout of the first and second voltage values, and a precise and reliable comparison of the first and second voltage values with the first and second diagnostic voltages.

According to one embodiment, the diagnostic module further comprises a diagnostic resistor, wherein the diagnostic resistor has a resistance which is higher than resistances of elements of the antenna structure.

It is hereby possible to achieve the technical advantage of enabling a precise voltage measurement of the voltage values. In this case, elements of the antenna structure may include in particular heating wires of the antenna structure.

According to a third aspect of the present invention, an antenna amplifier is provided which comprises a diagnostic module according to the present invention, according to one of the preceding embodiments, wherein the diagnostic module is integrated into the antenna amplifier.

It is hereby possible to achieve the technical advantage of being able to provide an improved antenna amplifier comprising a diagnostic module according to the present invention having the aforementioned technical advantages.

According to a fourth aspect of the present invention, an antenna system is provided which comprises an antenna amplifier, an antenna structure, wherein the antenna structure is integrated into a heating element for a vehicle window, and a diagnostic module according to one of the preceding embodiments is provided.

It is hereby possible to provide an improved antenna system comprising a diagnostic module having the aforementioned technical advantages.

The present invention is explained in greater detail below with reference to the figures. The following are shown:
Figure 1 depicts, schematically, an antenna system comprising an antenna structure and an antenna amplifier according to one embodiment,
Figure 2 depicts an equivalent circuit diagram of an antenna system comprising an antenna structure and an antenna amplifier according to one embodiment, and
Figure 3 depicts a flow chart of a method for determining a connection status between an antenna amplifier and an antenna structure according to one embodiment.

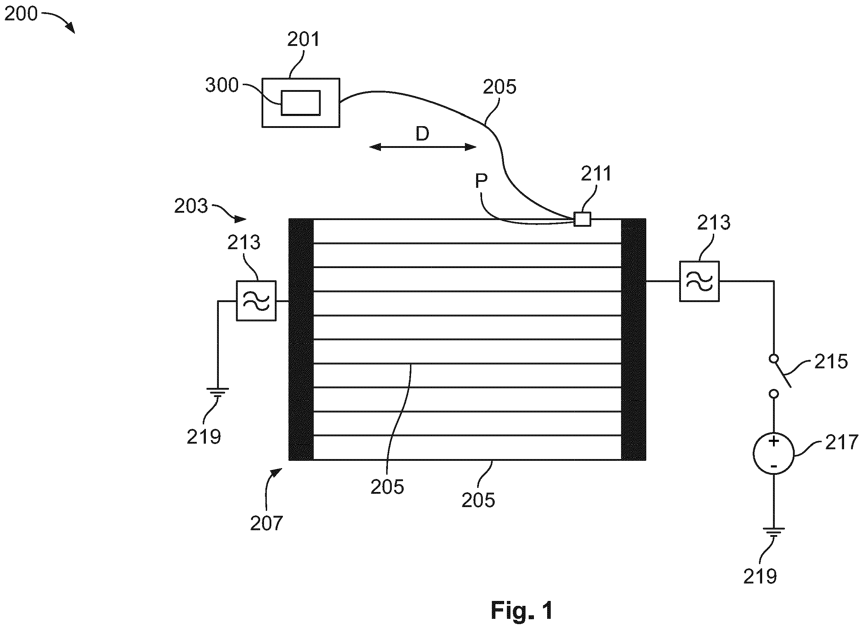

Figure 1 depicts, schematically, an antenna system 200 comprising an antenna amplifier 201 and an antenna structure 203 according to one embodiment.

In the embodiment shown, the antenna system 200 comprises an antenna amplifier 201 and an antenna structure 203. In the embodiment shown, the antenna structure 203 is integrated into a window heater 207 comprising a plurality of heating wires 205, wherein the antenna structure 203 comprises at least one of the heating wires 205 of the window heater 207. Alternatively, the antenna structure 203 may comprise a plurality of the heating wires 205 or all heating wires 205 of the window heater 207. Thus, the heating wires 205 serve both as heating elements of the window heater 207 and as elements of the antenna structure 203.

The heating element 207 further comprises a voltage source 217 and a switching element 215, by means of which the heating wires 205 may be energized and a corresponding heating effect may be achieved. Thus, via the circuit of the switching element 215, the heating wires 205 may be set to a potential of the voltage source 217 or to a potential of a ground 219.

The antenna structure 203 further comprises two filter elements 213, which are configured for example as low-pass filters, and by means of which it is possible to prevent highfrequency signals of the antenna structure 203 from entering the wiring of the voltage source 217 or the switching element 215 of the window heater 207.

The antenna amplifier 201 is connected to the antenna structure 203 via a connecting link 209. For this purpose, the connecting link 209 is arranged at a connecting point P on the antenna structure 203 via a connecting element 211. The connecting link 209 and the connecting element 211 may be formed for example as a plug element with a conductive connection line. Depending on the manufacturer of the antenna structure or the window heater 207 used, the provided connecting points P may vary along a direction D of the heating wires 205. Depending on the positioning of the connecting point P along the direction D, a potential applied to the respective connecting element 211 may vary.

In the embodiment shown, the antenna amplifier 201 further comprises a diagnostic module 300. The diagnostic module 300 is configured to carry out a method according to the present invention for determining a connection status between the antenna amplifier 201 and the antenna structure 203.

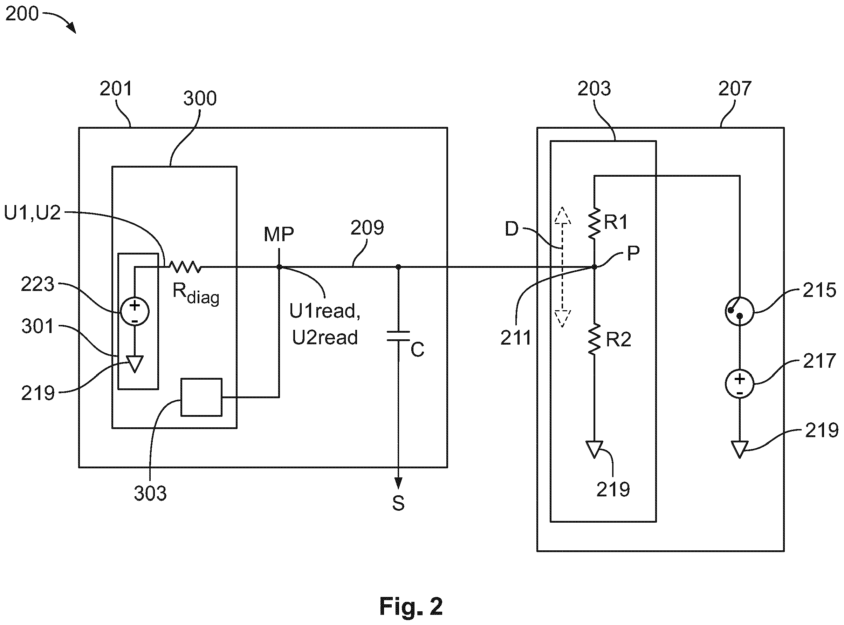

Figure 2 depicts an equivalent circuit diagram of an antenna system 200 comprising an antenna amplifier 201 and an antenna structure 203 according to one embodiment.

The equivalent circuit diagram shown describes an antenna system 200 according to the embodiment in Figure 1.

The antenna amplifier 201 is connected to the antenna structure 203 or window heater 207 via the connecting link 209. The connecting link 209 is connected to the antenna structure 203 at a connecting point P via the connecting element 211. In the embodiment shown, only one heating wire 205 of the antenna structure 203 or window heater 207 is shown, but this is not intended to limit the present invention. Alternatively, a plurality of heating wires 205 of the window heater 207 may be used as elements of the antenna structure 203.

Via the voltage source 217 and the switching element 215, the heating wire 205 may be correspondingly supplied with current. The heating wire 205 has electrical resistances R1, R2 which are influenced for example via the specific material properties and/or the length of the heating wire 205. The numerical values of the resistances R1, R2 depend in particular on a position of the connecting point P on the respective heating wire 205, via which the lengths of the two sections of the heating wire are influenced.

Furthermore, via a capacitor C, an antenna signal S of the antenna structure 203 may be output which is amplified accordingly by means of the antenna amplifier 201.

In the embodiment shown, the antenna amplifier 201 comprises the diagnostic module 300 according to the present invention. The diagnostic module 300 comprises a generation unit 301 and a readout unit 303. By means of the generation unit 301, diagnostic voltages U1, U2 may be generated and applied to the connecting link 209. For this purpose, the generation unit 301 comprises a voltage source 221. Here, the first and second diagnostic voltages U1, U2 are applied successively to the connecting link 209, relative to a ground potential. For this purpose, the generation unit 301 may for example comprise a microcontroller having a digital-to-analogue converter and/or a pulse width modulation output (both not shown in Figure 2). Via the digital-to-analogue converter, different DC voltages may be generated as first and second diagnostic voltages U1, U2 for different sampling frequencies. Alternatively or additionally, a DC voltage may be generated from the pulse width modulation signal of the pulse width modulation output by using an additional low-pass filter (also not shown in Figure 2). By varying the sampling frequency of the pulse width modulation output, it is thus possible to generate different DC voltages as first and second diagnostic voltages U1, U2.

The readout unit 303 is further configured to read out voltage values U1_{read}, U2_{read} sequentially at the connecting link 209, and to compare them with the correspondingly generated and applied diagnostic voltages U1, U2. For reading out the voltage values U1_{read}, U2_{read}, the readout unit 303 is connected to the connecting link 209 via a measuring point MP and is configured to read out the voltage present at the measuring point MP of the connecting link 209. The voltage at the measuring point MP is determined here as a difference in potential between a potential at the measuring point MP and a ground potential.

For comparing the read-out voltage values U1_{read}, U2_{read}, the readout unit 303 may comprise an analogue-to-digital converter and/or a comparator (both not shown in Figure 2). Via the analogue-to-digital converter, the analogue voltage signals of the read-out voltage values U1_{read}, U2_{read} may be sampled at a corresponding sampling frequency and converted into a digital signal. The digital signal may then be processed by the microcontroller and/or compared with the respectively applied first or second diagnostic voltage U1, U2 by means of the comparator.

The measurement point MP, at which the readout unit 303 reads out the voltage applied to the connecting link 209, may be positioned between a diagnostic resistor R_{diag} of the diagnostic module 300 which is connected to the connecting link 209, and the connecting point P at the connecting link 209. In this case, the diagnostic resistor R_{diag} must be formed having a substantially higher resistance value than the resistances R1, R2 of the elements of the antenna structure 203. The elements of the antenna structure 201 may be provided in particular by the heating wires 205 of the window heater 207. As a result of the high value of the diagnostic resistor R_{diag} in comparison with the resistances R1, R2, it is possible to prevent a current flow between the diagnostic module 300 and the antenna structure 203 due to the applied diagnostic voltages U1, U2. In addition, the diagnostic resistor R_{diag} makes it possible to read off different voltage values at the measuring point MP as a function of a voltage applied to the antenna structure 203.

As described with reference to Figure 1, the connecting point P, at which the antenna amplifier 201 is connected to the antenna structure 203, may vary for different manufacturers along the direction D of the heating wires 205, whereby the potential arising at the corresponding connecting element 211 may likewise assume different values.

In order to determine a connection status between the antenna amplifier 201 and the antenna structure 203 which indicates whether or not the antenna amplifier 201 is connected to the antenna structure 203, a first diagnostic voltage U1 is generated by the generation unit 301 of the diagnostic module 300 and applied to the connecting link 209. Via the readout unit 303, a corresponding first voltage value U1_{read} is read out at the measuring point and compared with the first diagnostic voltage U1. The first voltage value U1_{read} is read out at a time at which the first diagnostic voltage U1 is applied.

If the read-out first voltage value U1_{read} differs from the applied first diagnostic voltage U1, then a fault-free connection between the antenna amplifier 201 and the antenna structure 203 may be determined.

A deviation may occur here taking into consideration a limit value, so that voltage values U1_{read}, U2_{read} differ from the respective diagnostic voltage U1, U2 if a difference between the respectively applied diagnostic voltage and the respective measured voltage value is greater than the limit value. On the other hand, a read-out voltage value U1_{read}, U2_{read} corresponds to the respective diagnostic voltage U1, U2 if a difference between the voltage value U1_{read}, U2_{read} and the diagnostic voltage U1, U2 is less than or equal to the limit value.

In the circuit shown, in particular taking into consideration the diagnostic resistor R_{diag} and the measuring point MP arranged between the diagnostic resistor R_{diag} and the connecting point P, and by determining the voltage values U1_{read}, U2_{read} relative to a ground potential, in the case of a fault-free connection of the antenna amplifier 201 to the antenna structure 203 via the connecting point P, a voltage corresponding to the voltage present at the antenna structure 203 is measured by the readout unit 303 at the measuring point MP. In this case, the voltage value U1_{read}, U2_{read} which is read out at the measuring point MP is independent of the respective applied diagnostic voltage U1, U2 in the case of a fault-free connection of the antenna amplifier 201 to the antenna structure 203. In the case of the antenna amplifier 201 being connected, in which there is an electrical connection between the antenna amplifier 201 and the antenna structure 203, and in which there is thus an electrical connection between the measurement point MP and the connecting point P, a potential at the measurement point MP corresponds to a potential at the connecting point P. Thus, a voltage measurement at the measurement point MP determines a potential of the connecting point P.

However, in the case of a faulty connection of the antenna amplifier 201 to the antenna structure 203, there is no electrical connection between the measuring point MP and the connecting point P. If a voltage is measured at the measuring point MP, the potential at the measuring point MP is thus primarily influenced by the applied diagnostic voltage U1, U2.

In the case of a faulty connection in which the antenna amplifier 201 for example is not connected to the antenna structure 203, it would therefore be expected that the read-out voltage value U1_{read} corresponds to the applied first diagnostic voltage U1. Due to the circuit described above having the R_{diag} which is substantially higher in resistance in comparison to the resistances R1, R2 of the antenna structure 203 and the measuring point MP as arranged above, the readout unit 303 primarily measures the respective applied diagnostic voltage U1, U2 in the case of a faulty connection of the antenna amplifier 201 to the antenna structure 203 at the measuring point MP.

However, if the first voltage value U1_{read} corresponds to the first diagnostic voltage U1, it cannot yet be clearly determined at this point that there is a faulty connection between the antenna amplifier 201 and the antenna structure 203. Since, in the case of a faulty connection at the measuring point MP, the applied diagnostic voltage U1 is read out, while in the case of a fault-free connection at the measuring point, the voltage of the antenna structure 203 is read out, a correspondence of the first voltage value U1_{read} to the first diagnostic voltage U1 may be effected by a faulty connection or by a fault-free connection, wherein, in the case of a fault-free connection, a voltage applied to the antenna structure additionally matches the diagnostic voltage U1. This may occur in particular during operation of the window heater 207, in which the switching element 215 of the window heater 207 is closed and the heating wires 205 are energized via the voltage source 217. Depending on the design/dimensioning of the voltage source 217 and the characteristics of the window heater 207 and the heating wires 205, due to the operation of the window heater, there may be a voltage drop at the connecting point P which corresponds to the applied diagnostic voltage U1. Thus, without knowledge of the switching state of the switching element 215 or the operating state of the window heater, a clear conclusion cannot be made based on the first measurement.

According to the present invention, in the case that the read-out first voltage value U1_{read} corresponds to the applied first diagnostic voltage, a second diagnostic voltage U2 which differs from the first diagnostic voltage U1 is thus generated by the generation unit 301 and applied to the connecting link 209. A second voltage value U2_{read} is correspondingly read out by the readout unit 303 and compared with the applied second diagnostic voltage U2, wherein the readout is again performed at a time at which the second diagnostic voltage U2 is applied.

If the read-out second voltage value U2_{read} corresponds to the applied second diagnostic voltage U2, a faulty connection between the antenna amplifier 201 and the antenna structure 203 is determined. In such a case, both the first read-out voltage value U1_{read} corresponds to the first applied diagnostic voltage U1, and the second read-out voltage value U2_{read} corresponds to the second applied diagnostic voltage U2. Since the first and second diagnostic voltages U1, U2 are different, such a result is independent of the switching state and the potential of the switching element 215 of the window heater 207 and may be caused solely by a faulty connection between the antenna amplifier 201 and the antenna structure 203. A change in the voltage of the antenna structure 203 may be ruled out in this case, since the window heater is operated at a constant operating voltage and the connecting point P remains unchanged.

The faulty connection determined in such a way may be based for example on a faulty connection or a defect in the connecting link 209.

On the other hand, if the read-out second voltage value U2_{read} differs from the applied second diagnostic voltage U2, then a fault-free connection between the antenna amplifier 201 and the antenna structure 203 may be clearly determined. Since, as described above, in the case of a faulty connection at the measuring point MP, primarily the applied diagnostic voltage U2 is measured, not the voltage of the antenna structure, a deviation of the measured voltage values from the respective applied voltage can only be interpreted with a fault-free connection in which, as described above, primarily the voltage of the antenna structure 203 is measured at the measuring point MP.

According to one embodiment, the diagnostic voltages U1, U2 and correspondingly the read-out voltage values U1_{read}, U2_{read}, are configured as DC voltages.

The antenna structure 203 and the window antenna 207 may be integrated in particular into a rear window, a front window or a side window of a vehicle.

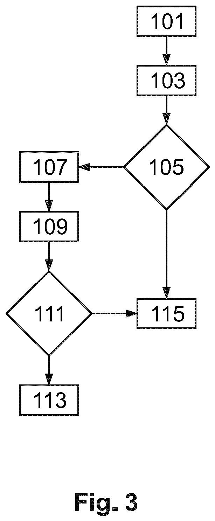

Figure 3 shows a flowchart of a method 100 for determining a connection status between an antenna amplifier 201 and an antenna structure 203, according to one embodiment.

The method 100 according to the present invention for determining a connection status between an antenna amplifier 201 and an antenna structure 203 may be applied to an antenna system 200 according to Figures 1 and 2 and carried out by a corresponding diagnostic module 300.

To determine the connection status, in a first step 101, a first diagnostic voltage U1 is first applied to the connecting link 209.

In a method step 103, a first voltage value U1_{read} is read out at the connecting link 209. The first voltage value U1_{read} is read out at a time at which the first diagnostic voltage U1 is applied to the connecting link 209. In this case, the first voltage value U1_{read} is read out at a measuring point MP on the connecting link 209 and determined as a difference in potential between a potential at the measuring point MP and a ground potential.

In a method step 105, the read-out first voltage value U1_{read} is compared with the applied first diagnostic voltage U1.

If the comparison shows that the read-out first voltage value U1_{read} differs from the applied first diagnostic voltage U1, a fault-free connection between the antenna amplifier 201 and the antenna structure 207 is determined in a method step 115.

If, however, the comparison in method step 105 shows that the read-out first voltage value U1_{read} corresponds to the applied first diagnostic voltage U1, then, in a method step 107, a second diagnostic voltage U2 which is different from the first diagnostic voltage U1 is applied to the connecting link 209.

In a method step 109, a second voltage value U2_{read} is read out at the connecting link 209, wherein said voltage value is read out analogously to the first voltage value U1_{read} at the measuring point MP and determined as a difference in potential between the potential of the measuring point and the ground potential. The second voltage value U2_{read} is read at a time at which the second diagnostic voltage U2 is applied to the connecting link 209.

In a method step 111, the read-out second voltage value U2_{read} is compared with the applied second diagnostic voltage U2.

If the comparison in method step 111 shows that the read-out second voltage value U2_{read} differs from the applied second diagnostic voltage U2, a fault-free connection between the antenna amplifier 201 and the antenna structure 203 is determined in method step 115.

If, however, the comparison in method step 111 shows that the read-out second voltage value U2_{read} corresponds to the applied second diagnostic voltage U2, a faulty connection between the antenna amplifier 201 and the antenna structure 203 is determined in a method step 113.

A diagnostic result with respect to the connection status according to the results of method steps 113, 115 may be displayed to a user according to a corresponding diagnostic message or by means of a diagnostic signal.

The method 100 according to the present invention may be carried out cyclically during an operation of the antenna amplifier 201 or the antenna structure 203, so that a corresponding connection status of the antenna amplifier 201 with the antenna structure 203 may be continuously displayed to a user via a corresponding status message or a corresponding status signal. Alternatively or additionally, by carrying out the method 100, a corresponding connection status may be displayed to the user during a switch-on operation of the antenna amplifier 201 or the antenna structure 203.

In deviation from the procedure described above, a plurality of different diagnostic voltages having respectively different values may be generated, applied to the connecting link 209, and corresponding voltage values may be read out and compared with the respective diagnostic voltages.

### List of reference signs

- 100: Method
- 101: Apply a voltage
- 103: Read out a voltage value
- 105: Compare a voltage value with a voltage
- 107: Apply a voltage
- 109: Read out a voltage value
- 111: Compare a voltage value with a voltage
- 113: Determine a faulty connection
- 115: Determine a fault-free connection

- 200: Antenna system
- 201: Antenna amplifier
- 203: Antenna structure
- 205: Heating wire
- 207: Window heater
- 209: Connecting wire
- 211: Connecting element
- 213: Filter element
- 215: Switching element
- 217: Voltage source
- 219: Ground
- 221: Voltage source

- 300: Diagnostic module
- 301: Generation unit
- 303: Readout unit

- U1: First diagnostic voltage
- U2: Second diagnostic voltage
- U1_{read}: First voltage value
- U2_{read}: Second voltage value
- R_{diag}: Diagnostic resistor
- R1: Resistance
- R2: Resistance
- C: Capacitor
- S: Antenna signal
- P: Connecting point
- MP: Measuring point
- D: Direction

## Claims

1. Method (100) for determining a connection status between an antenna amplifier (201) and an antenna structure (203), wherein the antenna structure (203) is configured as a window antenna for a vehicle and comprises at least one heating wire (205) of a window heater (207) for a vehicle, and wherein the method (100) is **characterised by**:
Applying (101) a first diagnostic voltage (U1) to a connecting link (209) between the antenna amplifier (201) and the antenna structure (203), and reading out (103) a first voltage value (U1_{read}) at a measuring point (MP) of the connecting link (209), wherein the first voltage value (U1_{read}) is determined as a difference in potential between a potential at the measuring point (MP) of the connecting link (209) and a ground potential;
Comparing (105) the first voltage value (U1_{read}) with the first diagnostic voltage (U1);
Applying (107) a second diagnostic voltage (U2), which is different from the first diagnostic voltage (U1), to the connecting link (209) and reading out (109) a second voltage value (U2_{read}) at the measuring point (MP) of the connecting link (209), wherein the second voltage value (U2_{read}) is determined as a difference in potential between a potential at the measuring point (MP) of the connecting link (209) and the ground potential; Comparing (111) the second voltage value (U2_{read}) with the second diagnostic voltage (U2); and
Determining (113) a faulty connection between the antenna amplifier (201) and the antenna structure (203) if the first voltage value (U1_{read}) corresponds to the first diagnostic voltage (U1) and the second voltage value (U2_{read}) corresponds to the second diagnostic voltage (U2) .

2. Method according to Claim 1, further comprising:
Determining (115) a fault-free connection between the antenna amplifier (201) and the antenna structure (203) if the first voltage value (U1_{read}) differs from the first diagnostic voltage (U1) and/or the second voltage value (U2_{read}) differs from the second diagnostic voltage (U2).

3. Method (100) according to Claim 1 or 2, wherein a faulty connection is indicated if the antenna amplifier (201) is not connected to the antenna structure (203) via a connecting element (211).

4. Method (100) according to one of the preceding claims,
wherein the first diagnostic voltage (U1) and the second diagnostic voltage (U2) are applied to the connecting link (209) via a diagnostic resistor (R_{diag}).

5. Method (100) according to one of the preceding claims,
wherein the first diagnostic voltage (U1) and/or the second diagnostic voltage (U2) and/or the first voltage value (U1_{read}) and/or the second voltage value (U2_{read}) are DC voltages.

6. Method (100) according to one of the preceding claims,
wherein the method (100) is carried out cyclically during an operation of the antenna amplifier (201) and the antenna structure (203).

7. Method (100) according to one of the preceding claims,
wherein the method (100) is carried out during a switch-on operation of the antenna amplifier (201) and/or the antenna structure (203).

8. Method (100) according to one of the preceding claims,
wherein the antenna structure (203) and the window heater (207) are integrated into a rear window or a front window or a side window of a vehicle.

9. Diagnostic module (300) for determining a connection status between an antenna amplifier (201) and an antenna structure (203), wherein the diagnostic module (300) is connectable to the antenna amplifier (201) and the antenna structure (203), **characterised in that** the diagnostic module (300) comprises a generation unit (301) for generating diagnostic voltages (U1, U2) and a readout unit (303) for reading out voltage values (U1_{read}, U2_{read}) and for comparing the voltage values (U1_{read}, U2_{read}) with the diagnostic voltages (U1, U2), and wherein the diagnostic module (300) is configured to carry out the method (100) for determining a connection status between an antenna amplifier (201) and an antenna structure (203) according to one of the preceding Claims 1 to 8.

10. Diagnostic module (300) according to Claim 9, wherein the generating unit (301) comprises a microcontroller,
wherein the microcontroller comprises a digital-to-analogue converter and/or a pulse width modulation output, and wherein the microcontroller is configured to generate the first diagnostic voltages (U1) and the second diagnostic voltages (U2).

11. Diagnostic module (300) according to Claim 9 or 10,
wherein the readout unit (303) comprises an analogue-to-digital converter and/or a comparator, and wherein the readout unit (303) is configured to compare the first voltage value (U1_{read}) with the first diagnostic voltage (U1) and to compare the second voltage value (U2_{read}) with the second diagnostic voltage (U2).

12. Diagnostic module (300) according to Claim 9, 10 or 11,
wherein the diagnostic module (300) further comprises a diagnostic resistor (R_{diag}), and wherein the diagnostic resistor (R_{diag}) has a resistance which is higher than resistances (R1, R2) of elements of the antenna structure (201) .

13. Antenna amplifier (201) comprising a diagnostic module (300) according to one of the preceding Claims 9 to 12, wherein the diagnostic module (300) is integrated into the antenna amplifier (201).

14. Antenna system (200) comprising an antenna amplifier (201), an antenna structure (203), wherein the antenna structure (203) is integrated into a heating element (207) for a vehicle window, and a diagnostic module (300) according to one of the preceding Claims 9 to 12.

## Patentansprüche

1. Verfahren (100) zum Bestimmen eines Verbindungszustands zwischen einem Antennenverstärker (201) und einer Antennenstruktur (203), wobei die Antennenstruktur (203) als eine Fensterantenne für ein Fahrzeug konfiguriert ist und mindestens einen Heizungsdraht (205) einer Fensterheizung (207) für ein Fahrzeug umfasst und wobei das Verfahren (100) **gekennzeichnet ist durch**:
Anlegen (101) einer ersten Diagnosespannung (U1) an ein Verbindungsglied (209) zwischen dem Antennenverstärker (201) und der Antennenstruktur (203) und Auslesen (103) eines ersten Spannungswerts (U1_{read}) an einem Messpunkt (MP) des Verbindungsglieds (209), wobei der erste Spannungswert (U1_{read}) als eine Potenzialdifferenz zwischen einem Potenzial an dem Messpunkt (MP) des Verbindungsglieds (209) und einem Erdpotenzial bestimmt wird;
Vergleichen (105) des ersten Spannungswerts (U1_{read}) mit der ersten Diagnosespannung (U1);
Anlegen (107) einer zweiten Diagnosespannung (U2), die von der ersten Diagnosespannung (U1) verschieden ist, an das Verbindungsglied (209) und Auslesen (109) eines zweiten Spannungswerts (U2_{read}) an dem Messpunkt (MP) des Verbindungsglieds (209), wobei der zweite Spannungswert (U2_{read}) als eine Potenzialdifferenz zwischen einem Potenzial an dem Messpunkt (MP) des Verbindungsglieds (209) und dem Erdpotenzial bestimmt wird;
Vergleichen (111) des zweiten Spannungswerts (U2_{read}) mit der zweiten Diagnosespannung (U2); und
Bestimmen (113) einer fehlerhaften Verbindung zwischen dem Antennenverstärker (201) und der Antennenstruktur (203), wenn der erste Spannungswert (U1_{read}) mit der ersten Diagnosespannung (U1) korrespondiert und der zweite Spannungswert (U2_{read}) mit der zweiten Diagnosespannung (U2) korrespondiert.

2. Verfahren nach Anspruch 1, ferner umfassend:
Bestimmen (115) einer fehlerfreien Verbindung zwischen dem Antennenverstärker (201) und der Antennenstruktur (203), wenn der erste Spannungswert (U1_{read}) von der ersten Diagnosespannung (U1) verschieden ist und/oder der zweite Spannungswert (U2_{read}) von der zweiten Diagnosespannung (U2) verschieden ist.

3. Verfahren (100) nach Anspruch 1 oder 2, wobei eine fehlerhafte Verbindung angezeigt wird, wenn der Antennenverstärker (201) nicht mit der Antennenstruktur (203) über ein Verbindungselement (211) verbunden ist.

4. Verfahren (100) nach einem der vorhergehenden Ansprüche, wobei die erste Diagnosespannung (U1) und die zweite Diagnosespannung (U2) an das Verbindungsglied (209) über einen Diagnosewiderstand (R_{diag}) angelegt werden.

5. Verfahren (100) nach einem der vorhergehenden Ansprüche, wobei die erste Diagnosespannung (U1) und/oder die zweite Diagnosespannung (U2) und/oder der erste Spannungswert (U1_{read}) und/oder der zweite Spannungswert (U2_{read}) Gleichstromspannungen sind.

6. Verfahren (100) nach einem der vorhergehenden Ansprüche, wobei das Verfahren (100) während eines Betriebs des Antennenverstärkers (201) und der Antennenstruktur (203) zyklisch ausgeführt wird.

7. Verfahren (100) nach einem der vorhergehenden Ansprüche, wobei das Verfahren (100) während eines Einschaltvorgangs des Antennenverstärkers (201) und/oder der Antennenstruktur (203) ausgeführt wird.

8. Verfahren (100) nach einem der vorhergehenden Ansprüche, wobei die Antennenstruktur (203) und die Fensterheizung (207) in ein hinteres Fenster oder ein vorderes Fenster oder ein Seitenfenster eines Fahrzeugs integriert sind.

9. Diagnosemodul (300) zum Bestimmen eines Verbindungszustands zwischen einem Antennenverstärker (201) und einer Antennenstruktur (203), wobei das Diagnosemodul (300) mit dem Antennenverstärker (201) und der Antennenstruktur (203) verbindbar ist, **dadurch gekennzeichnet, dass** das Diagnosemodul (300) eine Erzeugungseinheit (301) zum Erzeugen von Diagnosespannungen (U1, U2) und eine Ausleseeinheit (303) zum Auslesen von Spannungswerten (U1_{read}, U2_{read}) und zum Vergleichen der Spannungswerte (U1_{read}, U2_{read}) mit den Diagnosespannungen (U1, U2) umfasst, und wobei das Diagnosemodul (300) zum Ausführen des Verfahrens (100) zum Bestimmen eines Verbindungszustands zwischen einem Antennenverstärker (201) und einer Antennenstruktur (203) nach einem der vorhergehenden Ansprüche 1 bis 8 konfiguriert ist.

10. Diagnosemodul (300) nach Anspruch 9, wobei die Erzeugungseinheit (301) eine Mikrosteuerung umfasst, wobei die Mikrosteuerung einen Digital-zu-Analog-Wandler und/oder einen Impulsbreitenmodulationsausgang umfasst und wobei die Mikrosteuerung zum Erzeugen der ersten Diagnosespannungen (U1) und der zweiten Diagnosespannungen (U2) konfiguriert ist.

11. Diagnosemodul (300) nach Anspruch 9 oder 10, wobei die Ausleseeinheit (303) einen Analog-zu-Digital-Wandler und/oder einen Komparator umfasst und wobei die Ausleseeinheit (303) zum Vergleichen des ersten Spannungswerts (U1_{read}) mit der ersten Diagnosespannung (U1) und zum Vergleichen des zweiten Spannungswerts (U2_{read}) mit der zweiten Diagnosespannung (U2) konfiguriert ist.

12. Diagnosemodul (300) nach Anspruch 9, 10 oder 11, wobei das Diagnosemodul (300) ferner einen Diagnosewiderstand (R_{diag}) umfasst und wobei der Diagnosewiderstand (R_{diag}) einen Widerstand aufweist, der höher als Widerstände (R1, R2) von Elementen der Antennenstruktur (201) ist.

13. Antennenverstärker (201), umfassend ein Diagnosemodul (300) nach einem der vorhergehenden Ansprüche 9 bis 12, wobei das Diagnosemodul (300) in den Antennenverstärker (201) integriert ist.

14. Antennensystem (200), umfassend einen Antennenverstärker (201), eine Antennenstruktur (203), wobei die Antennenstruktur (203) in ein Heizungselement (207) für ein Fahrzeugfenster integriert ist, und ein Diagnosemodul (300) nach einem der vorhergehenden Ansprüche 9 bis 12.

## Revendications

1. Procédé (100) pour déterminer un état de connexion entre un amplificateur d'antenne (201) et une structure d'antenne (203), cette structure d'antenne (203) étant configurée comme une antenne de vitre pour un véhicule et comportant au moins un fil chauffant (205) d'un chauffe-vitre (207) pour un véhicule, et ce procédé (100) étant **caractérisé par**
l'application (101) d'une première tension de diagnostic (U1) sur une liaison de connexion (209) entre l'amplificateur d'antenne (201) et la structure d'antenne (203), et la lecture (103) d'une première valeur de tension (U1_{read}) en un point de mesure (MP) de la liaison de connexion (209), cette première valeur de tension (U1_{read}) étant déterminée comme une différence de potentiel au point de mesure (MP) de la liaison de connexion (209) et un potentiel de terre ;
la comparaison (105) de la première valeur de tension (U1_{read}) avec une première tension de diagnostic (U1) ;
l'application (107) d'une deuxième tension de diagnostic (U2), qui est différente de la première tension de diagnostic (U1), sur la liaison de connexion (209) et la lecture (109) d'une deuxième valeur de tension (U2_{read}) au point de mesure (MP) de la liaison de connexion (209), cette deuxième valeur de tension (U2_{read}) étant déterminée comme une différence de potentiel entre un potentiel au point de mesure (MP) de la liaison de connexion (209) et le potentiel de terre ;
la comparaison (111) de la deuxième valeur de tension (U2_{read}) avec la première tension de diagnostic (U2) ; et
la détermination (113) d'une connexion défectueuse entre l'amplificateur d'antenne (201) et la structure d'antenne (203) si la première valeur de tension (U1_{read}) correspond à la première tension de diagnostic (U1) et si la deuxième valeur de tension (U2_{read}) correspond à la deuxième tension de diagnostic (U2).

2. Procédé selon la revendication 1, comprenant en outre :
la détermination (115) d'une connexion sans défaut entre l'amplificateur d'antenne (201) et la structure d'antenne (203) si la première valeur de tension (U1_{read}) est différente de la première tension de diagnostic (U1) et/ou si la deuxième valeur de tension (U2_{read}) est différente de la deuxième tension de diagnostic (U2).

3. Procédé (100) selon la revendication 1 ou 2, dans lequel une connexion défectueuse est indiquée si l'amplificateur d'antenne (201) n'est pas connecté à la structure d'antenne (203) via un élément de connexion (211) .

4. Procédé (100) selon l'une quelconque des revendications précédentes, dans lequel la première tension de diagnostic (U1) et la deuxième tension de diagnostic (U2) sont appliquées sur la liaison de connexion (209) via une résistance de diagnostic (R_{diag}).

5. Procédé (100) selon l'une quelconque des revendications précédentes, dans lequel la première tension de diagnostic (U1) et/ou la deuxième tension de diagnostic (U2) et/ou la première valeur de tension (U1_{read}) et/ou la deuxième valeur de tension (U2_{read}) sont des tensions continues.

6. Procédé (100) selon l'une quelconque des revendications précédentes, ce procédé (100) étant exécuté cycliquement pendant une opération de l'amplificateur d'antenne (201) et de la structure d'antenne (203).

7. Procédé (100) selon l'une quelconque des revendications précédentes, ce procédé (100) étant exécuté pendant une opération de mise sous tension de l'amplificateur d'antenne (201) et/ou de la structure d'antenne (203).

8. Procédé (100) selon l'une quelconque des revendications précédentes, dans lequel la structure d'antenne (203) et le chauffe-vitre (207) sont intégrés dans une vitre arrière ou une vitre avant ou une vitre latérale d'un véhicule.

9. Module de diagnostic (300) pour déterminer un état de connexion entre un amplificateur d'antenne (201) et une structure d'antenne (203), ce module de diagnostic (300) pouvant être connecté à l'amplificateur d'antenne (201) et à la structure d'antenne (203), **caractérisé en ce que** le module de diagnostic (300) comporte une unité de génération (301) pour générer des tensions de diagnostic (U1, U2) et une unité de lecture (303) pour lire les valeurs de tension (U1_{read}, U2_{read}) et pour comparer les valeurs de tension (U1_{read}, U2_{read}) avec les tensions de diagnostic (U1, U2), et le module de diagnostic (300) étant configuré de façon à exécuter le procédé (100) pour déterminer un état de connexion entre un amplificateur d'antenne (201) et une structure d'antenne (203) selon une des revendications précédentes 1 à 8.

10. Module de diagnostic (300) selon la revendication 9, dans lequel l'unité de génération (301) comporte un microcontrôleur, ce microcontrôleur comportant un convertisseur numérique-analogique et/ou une sortie de modulation d'impulsions en durée, et ce microcontrôleur étant configuré de façon à générer les premières tensions de diagnostic (U1) et les deuxièmes tensions de diagnostic (U2).

11. Module de diagnostic (300) selon la revendication 9 ou 10, dans lequel l'unité de lecture (303) comporte un convertisseur analogique-numérique et/ou un comparateur, et dans lequel l'unité de lecture (303) est configurée de façon à comparer la première valeur de tension (U1_{read}) avec la première tension de diagnostic (U1) et à comparer la deuxième valeur de tension (U2_{read}) avec la deuxième tension de diagnostic (U2) .

12. Module de diagnostic (300) selon la revendication 9, 10 ou 11, ce module de diagnostic (300) comprenant en outre une résistance de diagnostic (R_{diag}), et cette résistance de diagnostic (R_{diag}) ayant une résistance qui est plus grande que les résistances (R1, R2) d'éléments de la structure d'antenne (201).

13. Amplificateur d'antenne (201) comportant un module de diagnostic (300) selon une des revendications 9 à 12, ce module de diagnostic (300) étant intégré dans l'amplificateur d'antenne (201).

14. Système d'antenne (200) comprenant un amplificateur d'antenne (201), une structure d'antenne (203), cette structure d'antenne (203) étant intégrée dans un élément chauffant (207) pour une vitre de véhicule, et un module de diagnostic (300) selon une des revendications 9 à 12.
